Europäisches Patentamt

European Patent Office

Office européen des brevets

(11) Veröffentlichungsnummer: **0 068 203**
**A1**

(12) ## EUROPÄISCHE PATENTANMELDUNG

(21) Anmeldenummer: 82105041.6

(22) Anmeldetag: 08.06.82

(51) Int. Cl.³: **H 03 F 1/52**, H 02 H 7/20

(30) Priorität: 16.06.81 DE 3123918

(43) Veröffentlichungstag der Anmeldung: 05.01.83
Patentblatt 83/1

(84) Benannte Vertragsstaaten: **DE FR GB IT**

(71) Anmelder: **SIEMENS AKTIENGESELLSCHAFT Berlin und München, Postfach 22 02 61, D-8000 München 22 (DE)**

(72) Erfinder: **Lenz, Michael, Ing.grad., Fischbachauer Strasse 3, D-8000 München 90 (DE)**
Erfinder: **Pohl, Günter, Ing.grad., Haydnstrasse 8, D-8033 Krailling (DE)**

(54) **Halbleiter-Leistungselement mit Schutzschaltung.**

(57) Erfindungsgemäß besteht die Schutzschaltung aus einem Spannungsteiler mit vier in Reihe geschalteten Widerständen, wobei der mittlere Teilerpunkt an der Basis eines Schutztransistors gelegt ist, während seine beiden Endpunkte mit einer Versorgungsklemme bzw. einer Ausgangsklemme verbunden sind. Die beiden stromführenden Anschlüsse des z.B. als npn-Transistor ausgebildeten Leistungselements L sind an je eine der beiden genannten Klemmen geschaltet, wobei im Falle der einen Klemme – im Gegensatz zur anderen Klemme – je ein Vorwiderstand vorgesehen ist. Ein als Sonde wirkender Transistor vom Leistungstyp des Schutzelements ist mit seinem Kollektor mit derjenigen stromführenden Elektrode des Leistungselements L verbunden, die ohne Vermittlung eines Vorwiderstands an die zugehörige Klemme gelegt ist.

0068203

Siemens Aktiengesellschaft      Unser Zeichen
Berlin und München             VPA 81 P 1081 E

## Halbleiter-Leistungselement mit Schutzschaltung

Die Erfindung betrifft ein Halbleiter-Leistungselement mit Schutzschaltung, in der das Leistungselement mit einem durch die Betriebsparameter des Leistungselements beeinflußten und aufgrund dieser Beeinflussung seinerseits die Betriebsparameter des Leistungselements steuernden Schutzelement - insbesondere monolithisch - zusammengefaßt ist.

Schutzschaltungen dieser Art sind bekannt. Ein Beispiel findet man in der DE-OS 26 42 146. Im allgemeinen kann man zu solchen Schaltungen folgendes feststellen.

Bei Leistungselementen in integrierten Schaltungen, z.B. in einem integrierten NF-Verstärker, soll der Betriebszustand des Leistungstransistors so eingestellt sein, daß die Betriebsparameter des Leistungstransistors im sicheren Arbeitsbereich, dem sog. SOA-Bereich, verbleiben. Zu diesem Zweck fragt man Strom und Spannung an dem betreffenden Leistungselement mittels entsprechender Sensoren ab und verknüpft die erhaltenen Werte über eine geeignete mathematische Relation . Die Überschreitung bestimmter Schwellwerte soll dann zur Leistungsbegrenzung in dem zu schützenden Transistor führen.

Mit dieser Aufgabe befaßt sich die genannten DE-OS sowie die Literaturstelle "IEEE Transactions on Consumer Electronics" Vol. CE-24, No. 3 (August 1978), S. 330 - 331. Die dort beschriebenen Möglichkeiten haben jedoch folgende Nachteile:

a) Die Verwendung einer oder mehrerer in Serie geschalteter Zenerdioden als Schutzelement bringt wegen der durch die bei der Herstellung der integrierten Schaltung angewandten Technologie festgelegten Zenerspannung starke

0068203

Einschränkungen für die Wahl des Einsatzpunktes der Regelung.

b) Die Zenerdiode wird ggf. auch bei Strömen bis 500 µA betrieben, wodurch die Schutzschaltung in einen Arbeitsbereich gelangt, in dem die Zenerdiode ihr Rauschmaximum hat. Sie wirkt dann als Rauschgenerator im Regelkreis der Schutzschaltung. Um die daraus resultierenden Rausch - und Stabilitätsprobleme zu beherrschen braucht man Tiefpässe mit relativ hohen Kapazitäten, was bei der Integration Schwierigkeiten bereitet.

c) Die Tiefpässe vergrößern außerdem die Totzeit und die Anlaufzeit der Regelung und führen u.U. zu einem stärkeren Überschwingen der Regelgröße, z.B. der Verlustleistung im Halbleiter-Leistungselement.

d) Zenerdioden haben einen positiven Temperaturkoeffizienten (TK). Dies führt dazu, daß - insbesondere bei Serienschaltung mehrerer Zenerdioden - der zu begrenzende Strom im Leistungselement nicht so stark absinkt, wie dies für eine auch bei höherer Betriebstemperatur ausreichende Sicherheit erforderlich wären.

Die Aufgabe der Erfindung ist es, hier eine Abhilfe zu bringen, indem die Erfindung eine Schaltung gemäß der eingangs gegebenen Definition angibt, in der man ohne Zenerdiode auskommt.

Hierzu wird gemäß der Erfindung vorgeschlagen, daß ein aus vier hintereinander geschalteten Widerständen bestehender Spannungsteiler mit seinem einen Endpunkt an eine Signalausgangsklemme und mit seinem anderen Endpunkt an eine Versorgungsklemme angeschlossen ist, daß dabei die stromführende Strecke des Leistungselements unter Vermittlung eines Vorwiderstandes an die eine der beiden genannten Klemmen angeschlossen ist, daß ferner die eine stromführende Elektrode eines das Schutzelement bildenden Transistors sowie der eine stromführende
Anschluß eines von zwei Transistoren vom Typ des Schutztransistors gebildeten Darlington transistors - ebenfalls
unter Vermittlung je eines Widerstands - an dieselbe Klemme angeschlossen ist, an der auch der mit der stromführenden
Strecke des Leistungselements in Reihe liegende Vorwiderstand verbunden ist, daß weiterhin mit der anderen der beiden Klemmen sowohl die zweite stromführende Elektrode des
Leistungselements als auch die eine stromführende Elektrode eines weiteren Transistors vom Typ des das Schutzelement
bildenden Transistors unmittelbar verbunden ist, während
die Steuerelektrode dieses weiteren Transistors mit der
Steuerelektrode des Leistungslements unmittelbar verbunden
und die andere stromführende Elektrode dieses weiteren
Transistors an denjenigen Teilerpunkt des Spannungsteilers
angelegt ist, der derjenigen der beiden Klemmen am nächsten
liegt, mit der die stromführenden Strecken des Leistungselements sowie der Schutztransistor als auch der Darlingtontransistor mit je einem Vorwiderstand verbunden sind, und
daß schließlich der mittlere Teilerpunkt des Spannungsteilers an der Steuerelektrode des Schutztransistors und der
letzte Teilerpunkt des Spannungsteilers an der Steuerelektrode und der Stromausgangselektrode des Darlingtontransistors liegt.

Das Leistungselement ist in den meisten Fällen durch einen Bipolartransistor, insbesondere vom npn-Typ, gegeben.
In diesem Falle sind die beiden stromführenden Anschlüsse
durch den Emitter und den Kollektor und die Steuerelektrode durch den Basisanschluß des Bipolartransistors gegeben.
Bei Verwendung eines Feldeffekttransistors als Leistungselement sind die beiden stromführenden Elektroden durch
den Source- bzw. den Drainanschluß und die Steuerelektrode
durch das Gate gegeben. Der Feldeffekttransistor kann sowohl durch einen Junction-FET, als auch durch einen MOS-
FET gegeben sein. Zweckmäßig wird man in den genannten Fällen aus technologischen Gründen die verwendeten Transistoren an den Typ des Leistungselements anpassen. Im Falle der Verwendung eines npn-Transistors als Leistungselement hat man dann - wenigstens zumeist - nur npn-Transistoren für die in der Definition der Erfindung angegebenen Transistoren, d.h. also für den Schutztransistor, für die den Darlingtontransistor zusammensetzenden beiden Transistoren ( bzw. mehrere Transistoren) und den weiteren Transistor. Die Versorgungsklemme kann im einen Fall durch das erste Versorgungspotential U1 und im anderen Fall durch das Bezugspotential beaufschlagt sein. Im ersten Fall liegen die genannten Vorwiderstände zweckmäßig an der Anschlußklemme, im zweiten Fall hingegen an der Versorgungsklemme.

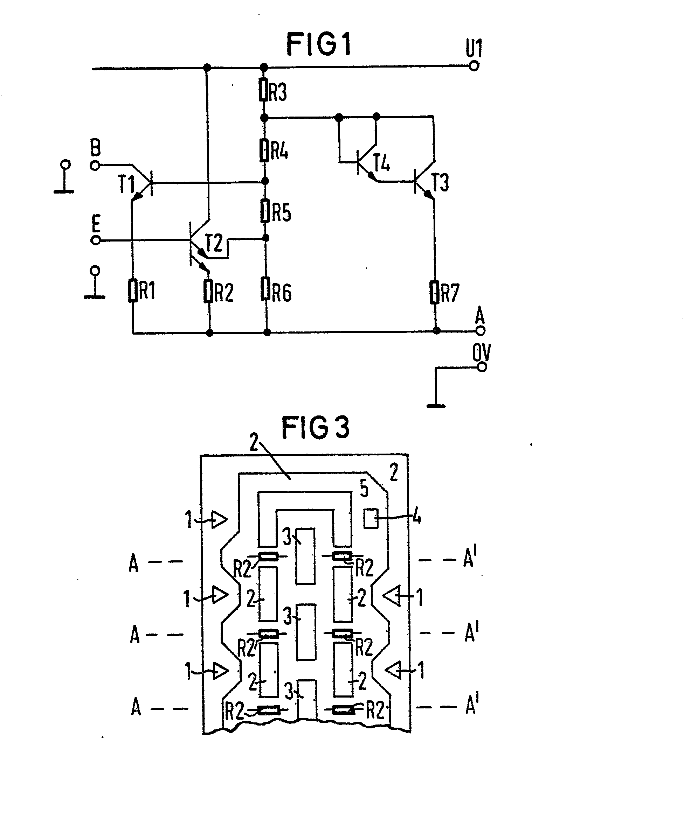

In Figur 1 ist eine der Erfindung entsprechende Kombination eines npn-Leistungstransistors mit einer Schutzschaltung gezeigt, wobei die in der Schutzschaltung verwendeten Transistoren ebenfalls vom npn-Typ sind. Der zu schützende npn-Leistungstransistor L ist in diesem Falle mit dem npn-Transistor T2 derart zusammengefaßt, daß beide Transistoren einen gemeinsamen Kollektor und eine gemeinsame Basis haben. Diese Ausgestaltung ist hinsichtlich des Verbrauchs an Chip-Fläche sparsamer, als wenn man neben dem Leistungstransistor L einen vollständigen zweiten npn-Transistor T2 vorsehen würde, dessen Kollektor in gleicher Weise wie der Kollektor des Leistungstransistors L an die das erste Versorgungspotential U1 führende Versorgungsklemme zu legen ist. Diese andere Ausführungsform ist aber ebenfalls als eine Ausführung der Erfindung zu betrachten. Bei dieser Ausführungsform ist dann noch zu bemerken, daß die Basisanschlüsse des Leistungstransistors L und des als Sonde wirkenden Transistors T2 miteinander leitend verbunden sind.

Der Spannungsteiler besteht aus den vier in Serie liegenden Widerständen R3, R4, R5 und R6, wobei der freie Anschluß des Widerstands R3 an der das erste Versorgungspotential U1 führenden Anschlußklemme gemeinsam mit dem Kollektor der aus dem Leistungstransistor L und der Sonde T2 bestehenden Transistorkombination gelegt ist. Der zwischen dem Widerstand R3 und dem folgenden Widerstand R4 in der Teilerkette liegende Teilerpunkt ist mit dem Signalausgang und der Steuerelektrode einer aus zwei (oder mehreren) npn-Transistoren T3, T4 bestehenden Darlingtonstufe verbunden. Der zwischen dem Widerstand R4 und dem folgenden Widerstand R5 liegende - mittlere - Teilerpunkt ist mit der Basis des als Schutzelement vorgesehenen npn-Transistors T1 verbunden. Der zwischen dem Widerstand R5 und dem letzten Widerstand R6 der Teilerkette liegende Teilerpunkt ist an den Emitter des Sondentransistors T2 angeschlossen, während der freie Anschluß des vierten Widerstands R6 der Teilerkette an der Ausgangsklemme A der Schaltung liegt.

Der Emitter des Leistungstransistors L sowie der Emitter des Schutztransistors T1 liegen über je einen Widerstand R2 bzw. R1 ebenfalls an der besagten Ausgangsklemme A. Die genannte Darlingtonstufe besteht aus den beiden genannten npn-Transistoren T3 und T4, wobei die Basis des ersten Transistors T4 mit dem Kollektor dieses Transistors, mit dem Kollektor des zweiten Transistors T3 sowie mit dem dem Betriebspotential U1 am nächsten liegenden Teilerpunkt (also dem Teilerpunkt zwischen R3 und R4) verbunden ist. Der Emitter des ersten Transistors der Darlingtonstufe , also des Transistors T4, ist mit der Basis des zweiten Transistors T3 der Darlingtonstufe verbunden, während der Emitter des zweiten Transistors T3 der Darlingtonstufe über den Widerstand R7 mit derselben Ausgangsklemme A verbunden ist, an die auch der Emitter des Leistungstransistors L bzw. des Schutztransistors T1 unter Verwendung je eines Widerstands R2 bzw. R3 angeschaltet sind.

Zu bemerken ist noch, daß die Basis des Leistungstransistors L und damit auch die Basis des als Sonde funktionierenden Transistors T2 an einer Eingangsklemme E und die Bais des Schutztransistors T1 an einer zweiten Eingangsklemme B liegen. Beide Anschlüsse sowie die Ausgangsklemme A sind auf einen das als Bezugspotential dienende Versorgungspotential führenden Versorgungsanschluß (Masse) bezogen, so daß also das Ausgangssignal zwischen der Klemme A und dem das Bezugspotential führenden Masseanschluß abzunehmen ist, während ein Eingangssignal an die Klemme E bzw. B und den Masseanschluß zu legen ist.

Der Transistor L ist das zu schützende Leistungselement, zu dem man auch unter gewisser Berechtigung den Sondentransistor T2 rechnen kann. Häufig wird man den Leistungstransistor L im Interesse einer gleichförmigeren Wärmeverteilung durch mehrere einander gleiche und einander parallel geschaltete npn-Transistoren , die vorzugsweise monolithisch zusammengefaßt sind, realisieren. Aufgabe der Schaltung ist es, den Kollektorstrom der Transistoren L und T2 bzw. die Emitter-Kollektorspannung $U_{EC}$ des Leistungstransistors L so zu begrenzen, daß die SOA-Grenze nicht überschritten wird.

Die Widerstände R2 und R6 sind die zur Gleichverteilung der Leistung dienenden Emitterwiderstände, die sich aus der Geometrie des Leistungstransistors L und des Sondentransistors T2 ergeben. Es ist von Vorteil, wenn der Leistungstransistor L und damit sein Emitterstrom um Größenordnungen, z.B. um den Faktor 100, größer als der Sondentransistor T2 und damit dessen Emitterstrom bemessen ist und sich die zugehörigen Emitterwiderstände R6 und R2 hierzu umgekehrt proportional verhalten, so daß also in dem Beispielsfall R6 100·R2 sein würde.

Der Strom durch den an der Klemme A liegenden Widerstand R6 des Spannungsteilers und somit der aufgrund dieses Stromes entstehende Spannungsabfall längs dieses Widerstands R6 wird jedoch nicht nur von dem Flächenverhältnis von T2 zu L

0068203

entsprechenden Teilstrom des Leistungselements L sondern auch von dem Strom durch den Widerstand 5, also des näher an der Ausgangsklemme A liegenden mittleren Widerstands im Spannungsteiler bestimmt. Dieser Strom ist bei kleiner Kollektor-Emitterspannung $U_{CE}$ des Leistungstransistors L (die bis auf den Spannungsabfall am Emitterwiderstand R2 des Leistungstransistors L der Spannung zwischen dem ersten Betriebspotential U1 und der Ausgangsklemme A entpricht) von der Summe der Werte der Widerstände R3 - R6 im Spannungsteiler linear abhängig, da dann die Transistoren T4 und T3 noch gesperrt sind.

Bei größeren Werten der Emitter-Kollektorspannung $U_{EC}$ des Leistungstransistors L wird die Schaltschwelle in den beiden Transistoren T3 und T4 der Darlingtonstufe überschritten, so daß der Strom über den Teilwiderstand R5 zusätzlich einen Anteil erhält, der logarithmisch von der Emitter-Kollektorspannung $U_{EC}$ des Leistungstransistors L abhängt. Damit liegt an der Basis des Schutztransistors T1 eine vom Kollektorstrom $I_C$ der beiden Transistoren L und T2 abhängige Steuerspannung, die - ebenso wie die SOA-Grenzlinie - einen linearen und einen logarithmischen Verlauf hat. Unter Berücksichtigung der Eingangskennlinie des Schutztransistors T1 stellt diese Steuerspannung die zulässigen Arbeitspunkte des Leistungselements L im SOA-Bereich ein, wenn man den Begrenzerausgang B, d.h. also den Kollektoranschluß des Schutztransistors T1, direkt oder über ein geeignetes Netzwerk mit dem Signaleingang E des Leistungstransistors L verbindet. Mittels des Widerstands R1 kann die Verstärkung des Schutztransistors T1 eingestellt, z.B. auch reduziert, werden.

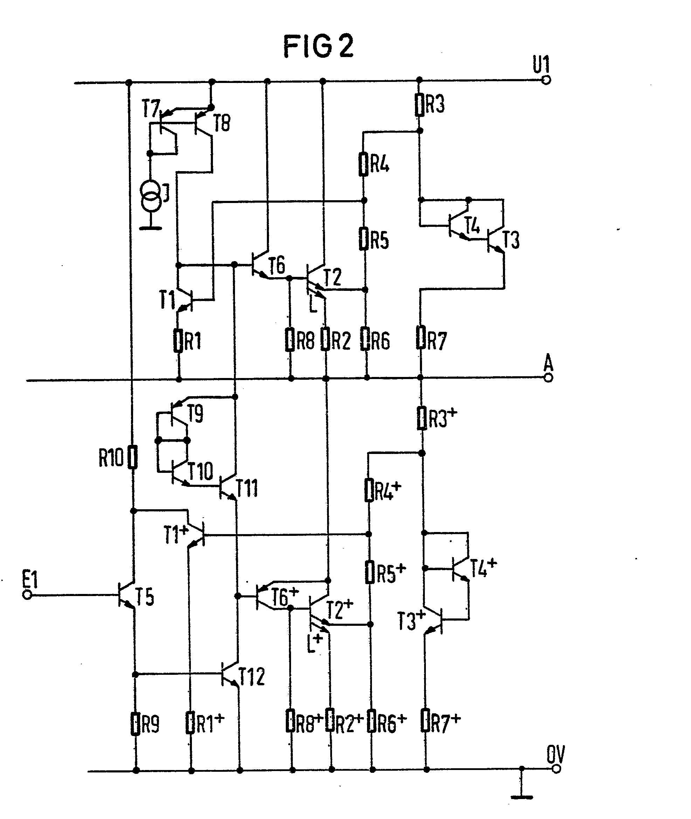

In Fig. 2 ist das Schaltbild für ein Beispiel der Anwendung des erfindungsgemäß geschützten Leistungstransistors L gezeigt. Dabei handelt es sich um eine Gegentaktendstufe eines Leistungsverstärkers. Der der Schutzschaltung gemäß Figur 1 entsprechende Schaltungsteil ist durch den Leistungstransistor L, die Transistoren T1 bis T4 und die Widerstände R1 bis R7 gegeben, die in der bereits beschriebenen Weise geschaltet sind. Der Eingang E, d.h. also die Basis des Leistungstransistors L und damit die des Transistors T2, sind in einer Emitterfolgerschaltung an den Emitter eines npn-Transistors T6 gelegt, der außerdem über einen Widerstand R8 an die gemeinsame Ausgangsklemme A der Schutzschaltung gelegt ist. Die Basis dieses npn-Transistors T6 ist mit dem Kollektor des Schutztransistors T1 verbunden (der den Eingang B in Figur 1 darstellt). Der Kollektor dieses Schutztransistors T1 liegt über der Emitter-Kollektorstrecke eines pnp-Transistors T8 in noch zu beschreibender Weise an der Klemme für das erste Versorgungspotential U1, während der Kollektor des in Emitterfolgerschaltung betriebenen npn-Transistors T6 – ebenso wie der Kollektor des Leistungstransistors L – unmittelbar mit der besagten Versorgungsklemme U1 verbunden ist.

Um die Verbindung des Anschlusses B des Schutztransistors T1, d.h. also dessen Kollektor, mit der Versorgungsklemme U1 zu gewährleisten, ist, wie bereits bemerkt, ein pnp-Transistor T8 vorgesehen. Der Emitter dieses pnp-Transistors T8 liegt an der das Versorgungspotential U1 führenden Anschlußklemme, während sein Kollektor mit dem Kollektor des Schutztransistors T1 unmittelbar verbunden ist. Ein zweiter pnp-Transistor T7 liegt mit seinem Emitter ebenfalls an der besagten Versorgungsklemme U1 und ist mit seinem Kollektor sowie mit seiner Basis mit der Basis des pnp-Transistors T8 verbunden. Beide pnp-Transistoren bilden eine Stromspiegel-Konstantstromquelle, indem von einer auf das Bezugspotential bezogenen Stromquelle, z.B. einem Transistor, ein Strom J an den als Diode geschalteten pnp-Transistor T7 gegeben wird. Durch den Ausgangsstrom des Stromspiegels wird der über den Schutztransistor T1 fließende Strom eingestellt.

0068203

Der Eingang E1 des Verstärkers ist durch die Basis eines npn-Transistors T5 gegeben, dessen Emitter über einen Widerstand R9 am Bezugspotential (0 V) der Schaltung, also an Masse, liegt und dessen Kollektor über einen weiteren Widerstand R10 an die das erste Versorgungspotential U1 führenden Anschlußklemme der Schaltung gelegt ist. Ferner ist der Kollektor des Eingangstransistors T5 mit dem Kollektor eines weiteren npn-Transistors $T1^+$ verbunden, wobei der Emitter dieses weiteren npn-Transistors $T1^+$ über einen Widerstand $R1^+$ an das Bezugspotential gelegt ist. Dieser npn-Transistor $T1^+$ gehört zu einem Schaltungsteil des Gegentaktverstärkers, der ebenfalls eine Schutzschaltung für den zweiten Leistungstransistor $L^+$ des Gegentaktverstärkers bildet. Der npn-Transistor $T1^+$ entspricht dabei an sich dem Schutztransistor T1 in der zum Leistungstransistor L gehörenden Schutzschaltung gemäß der Erfindung.

Die dem zweiten Leistungstransistor $L^+$ zugehörige Schutzschaltung hat ebenfalls einen aus vier hintereinandergeschalteten Widerständen $R3^+$, $R4^+$, $R5^+$ und $R6^+$ bestehenden Spannungsteiler, der mit seinem einen Ende an die das Bezugspotential führende Versorgungsklemme und mit seinem anderen Ende, d.h. also dem Widerstand $R3^+$, an die - bereits mit der oberen Schutzschaltung für den Leistungstransistor L verbundene - Ausgangsklemme A gelegt ist. Der Leistungstransistor $L^+$ entspricht bezüglich seiner Dimensionierung und auch im übrigen völlig dem Leistungstransistor L. Ebenso wie dieser ist auch der Leistungstransistor $L^+$ mit einem weiteren, dem Sondentransistor T2 entsprechenden npn-Transistor $T2^+$ zusammengefaßt. Dabei liegt der Emitter des zweiten Leistungstransistors $L^+$ über einen Widerstand $R2^+$ (der in der Bemessung dem Widerstand R2 gleich ist) am Bezugspotential und der Emitter des Sondentransistors $T2^+$ an dem dem Bezugspotential am nächsten liegenden Teilerpunkt des - in der Dimensionierung mit dem Spannungsteiler in der oberen Schutzschaltung völlig übereinstimmenden - Spannungsteilers $R3^+ - R6^+$ in der zweiten, d.h. auf den zweiten Leistungstransistor $L^+$ bezogenen Schutzschaltung. Der mittlere Teilerpunkt des Spannungsteilers $R3^+$- $R6^+$ ist mit dem Basisanschluß des Schutztransistors $T1^+$ verbunden, während der letzte Teilerpunkt, d.h. also der der Anschlußklemme A am nächsten liegende Teilerpunkt dieses Spannungsteilers $R3^+$- $R6^+$ wiederum an einem Darlingtontransistor $T3^+$, $T4^+$ liegt (beide Transistoren sind vom npn-Typ und entsprechen in der Dimensionierung den Transistoren der Darlingtonstufe T3, T4 in der ersten Schutzschaltung). Der Emitter des Transistors $T3^+$ liegt wiederum über einen (dem Widerstand R7 gleichen) Widerstand $R7^+$ am Fußpunkt der Schutzschaltung, d.h. in diesem Falle an der das Bezugspotential 0 V führenden Versorgungsklemme.

Abgesehen von der unterschiedlichen Funktion der über den Vorwiderstand R2 an den Emitter des npn-Leistungstransistors L bzw. $L^+$ liegenden Klemme A bzw. Versorgungsklemme mit dem Bezugspotential ist als weiterer Unterschied zwischen den beiden in Figur 2 vereinigten Schutzschaltungen nur noch festzustellen, daß im ersten Fall die Verbindung zwischen dem Kollektorausgang B des Schutztransistors T1 über einen npn-Transistor T6 und im zweiten Fall über einen pnp-Transistor $T6^+$ gegeben ist.

Im ersten Fall liegt die Basis des npn-Leistungstransistors L in Emitterfolgerschaltung an dem Emitter des npn-Transistors T6, dessen Basis am Kollektor des Schutztransistors T1 und dessen Kollektor an der das erste Versorgungspotential U1 führenden Klemme unmittelbar angeschlossen ist. Außerdem ist der Emitter des npn-Transistors T6 über einen Widerstand R8 an die gemeinsame Ausgangsklemme A gelegt.

Im zweiten Falle liegt die Basis des npn-Leistungstransistors $L^+$ - ebenfalls über einen Widerstand $R8^+$- an der das Bezugspotential 0 V führenden Versorgungsklemme, mit der auch der Emitter des Leistungs-npn-Transistors $L^+$ über den Vorwiderstand $R2^+$ verbunden ist. Außerdem ist sie aber mit dem Kollektor des pnp-Transistors $T6^+$ verbunden während der Kollektor dieses pnp-Transistors T6$^+$ - zusammen mit dem Kollektor des npn-Leistungstransistors L$^+$ - an der gemeinsamen Ausgangsklemme A liegt. Ferner ist die Basis des pnp-Transistors T6$^+$ an den Kollektor des Treibertransistors T12 angeschlossen, der über eine Ruhestromkombination - bestehend aus den Transistoren T9, T10 und T11 - beide Endstufen-Transistoren steuert.

Hierzu ist der erste npn-Transistor T11 mit seinem Kollektor an den Kollektor des pnp-Transistors T8 und damit an den Ausgang des bereits zur Versorgung des Schutztransistors T1 der ersten Schutzschaltung dienenden Stromspiegelverstärkers T7, T8 gelegt. Außerdem ist die Basis dieses npn-Transistors T11 mit dem Kollektor durch die Reihenschaltung zweier gleichläufig gepolter Dioden T9 und T10 überbrückt. Zur Realisierung der beiden Dioden wird man zweckmäßig den Kollektor eines pnp-Transistors T9 mit dem Kollektor eines npn-Transistors T10 sowie mit den Basisanschlüssen dieser beiden Transistoren verbinden und den Emitter des pnp-Transistors T9 an den Ausgang des Stromspiegels und den Emitter des npn-Transistors T10 an die Basis des npn-Transistors T11 legen. Der Emitter des npn-Transistors T11 führt zur Basis des die Verbindung zum Leistungstransistor L$^+$ herstellenden pnp-Transistors T6$^+$ sowie zum Kollektoranschluß eines weiteren npn-TransistorsT12. Dieser liegt mit seiner Basis unmittelbar am Emitter des bereits oben genannten Eingangs-npn-Transistors T5 und mit seinem Emitter unmittelbar an der das Bezugspotential 0 V führenden Anschlußklemme.

Damit ist die in Figur 2 dargestellte Schutzschaltung gemäß der Erfindung für einen Gegentaktverstärker beschrieben. Ihrer Realisierung in monolithischer Integrationstechnik stehen ersichtlich keine besonderen Probleme entgegen.

Wie bereits angedeutet, arbeiten die beiden pnp-Transistoren T7 und T8 als Stromübersetzung für den Konstantstrom J. Der npn-Transistor T6 und der pnp-Transistor T6$^+$ arbeiten als Treibertransistoren für den Leistungstransistor L bzw. L$^+$ und der zugehörigen Transistorsonde T2 bzw. T2$^+$, welche durch die Widerstände R8 bzw. R8$^+$ ausgeräumt werden. Die Transistoren T9, T10 und T11 bestimmen in bekannter Weise den Ruhestrom der Ausgangsstufen des Gegentaktverstärkers. Der Signaleingang E1 arbeitet als Vorverstärker, der aus dem Eingangs-npn-Transistor T5, dem npn-Transistor T12, dem Widerstand R9 und dem Widerstand R10 besteht.

In Figur 3 ist ein bei monolithischer Realisierung der Schaltung gemäß der Erfindung vorzugsweise anzuwendendes Layout und damit eines Teiles der Geometrie bezüglich der Kombination des Leistungstransistors L bzw. L$^+$ mit dem zugehörigen Sondentransistor gezeigt. Außerdem ist in dem Layout der Widerstand R6 des Spannungsteilers sowie der Vorwiderstand R2 zum Emitter des Leistungstransistors L berücksichtigt. Das Gebiet 1 bezeichnet den Basisanschluß für das Basisgebiet 2 der beiden Transistoren L und T2. Das Emitter-Diffusionsgebiet 5 ist im Bereich 3 für den Leistungstransistor L und im Bereich 4 für den Sondentransistor T2 angeschlossen. Das Gebiet 6 ist das gemeinsame Kollektorgebiet des Leistungstransistors L und des Sondentransistors T2. Der Widerstand R2 bildet sich längs den Linien A-A' aus. Der Widerstand R6 liegt in der Nähe des Gebietes 4.

Es ist ohne weiteres möglich, anstelle der npn-Transistoren pnp-Transistoren und dann anstelle der pnp-Transistoren npn-Transistoren zu verwenden. Ebenso besteht im Prinzip die Möglichkeit, die Transistoren durch Feldeffekttransistoren entsprechenden Kanaltyps, insbesondere auch durch selbstsperrende oder selbstleitende MOS-FET's, zu ersetzen.

Durch die Erfindung werden ersichtlich die oben genannten Nachteile der bekannten und auf Grundlage von Zenerdioden arbeitenden Schaltungen vermieden. Außerdem bringt die Erfindung noch folgende Vorteile:

0068203

a) Der Einsatzpunkt der durch die erfindungsgemäße Schutzschaltung gegebenen Regelung kann durch die Widerstandsverhältnisse von R3 - R7 und die Zahl der im Darlingtontransistor vereinigten Transistoren frei gewählt werden.

b) Da die Schaltung implizit Rausch und Stabilitätsprobleme ausschaltet, sind in der Schaltung keine zur Beseitigung dieser Störeffekte dienende Maßnahem erforderlich.

c) Aufgrund der in b) angegebenen Eigenschaften wird der Betrieb der Schutzschaltung gegenüber den bekannten Möglichkeiten beschleunigt.

d) Schließlich besitzt die erfindungsgemäße Schaltung einen negativen TK. Damit sinkt bei steigender Temperatur der zu begrenzende Strom des Leistungselements stärker ab, wodurch die Betriebssicherheit der Anordnung weiter erhöht wird.

Zu bemerken ist noch  im Hinblick auf Figur 2, daß - wie bereits angedeutet - hinsichtlich der einander entsprechenden Schaltungsteile der Schutzschaltung und hinsichtlich der Bemessung der Widerstände weitegehende Symmetrie gegeben ist. Eine Ausnahme bilden jedoch die an den Emittern der Schutztransistoren T1 und T1$^{+}$ liegenden Vorwiderstände R1 und R1$^{+}$. Hierzu ist zu sagen, daß die Widerstandswerte von R1 und R1$^{+}$ passend zu dem Strom J bzw. zu dem Widerstand R10 gewählt werden müssen.

3 Figuren

6 Patentansprüche

Patentansprüche

1.) Halbleiter-Leistungselement mit Schutzschaltung, in der das Leistungslement mit einem durch die Betriebsparameter des Leistungselements beeinflußten und aufgrund dieser Beeinflussung seinerseits die Betriebsparameter des Leistungselements steuernden Schutzelement - insbesondere monolithisch - zusammengefaßt ist, dadurch gekennzeichnet, daß ein aus vier hintereinander geschalteten Widerständen (R3 - R6) bestehender Spannungsteiler mit seinem einen Endpunkt an eine Signalausgangsklemme (A) und mit seinem anderen Endpunkt an eine Versorgungsklemme angeschlossen ist, daß dabei die stromführende Strecke des Leistungselements (L) unter Vermittlung eines Vorwiderstands (R2) an die eine der beiden genannten Klemmen angeschlossen ist, daß ferner die eine stromführende Elektrode eines das Schutzelement bildenden Transistors (T1) sowie der eine stromführende Anschluß eines von wenigstens zwei Transistoren vom Typ des Schutztransistors (T2) gebildeten Darlingtontransistors (T3, T4) - ebenfalls unter Vermittlung je eines Widerstands - an dieselbe Klemme angeschlossen ist, mit der auch der mit der stromführenden Strecke des Leistungselements (L) in Reihe liegende Vorwiderstand (R2) verbunden ist, daß weiterhin mit der anderen der beiden Klemmen sowohl die zweite stromführende Elektrode des Leistungselements (L) als auch eine stromführende Elektrode eines weiteren Transistors (T2) vom Typ des das Schutzelement bildenden Transistors (T1) unmittelbar verbunden ist, während die Steuerelektrode dieses weiteren Transistors (T2) mit der Steuerelektrode des Leistungselements (L) unmittelbar verbunden und die andere stromführende Elektrode dieses weiteren Transistors (T2) an denjenigen Teilerpunkt des Spannungsteilers (R3-R6) angelegt ist, der derjenigen der beiden Klemmen am nächsten liegt, mit der die stromführenden Strecken des Leistungselements (L) sowie des Schutztransistors (T1) als auch des Darlingtontransistors (T3, T4) mit je einem Vorwiderstand (R2, R1, R7) verbunden sind, und daß schließlich der mittlere Teilerpunkt des Spannungsteilers an der Steuerelektrode des Schutztransistors (T1) und der letzte Teilerpunkt an der Steuerelektrode und der Stromausgangselektrode des Darlingtontransistors liegt.

2.) Anordnung nach Anspruch 1, dadurch gekennzeichnet, daß das Leistungselement durch einen Bipolartransistor (L) und die genannten Transistoren, d.h. also der Schutztransistor (T1) , die den Darlingtontransistor bildenden Transistoren (T3, T4) und der bezüglich seiner Stromausgangselektrode (also seinem Kollektor) und seiner Steuerelektrode mit der entsprechenden Elektrode des Leistungstransistors (L) verbundene Sondentransistor (T2), vom Leitungstyp des Leistungselements, insbesondere vom npn-Typ, sind.

3.) Anordnung nach Anspruch 2, dadurch gekennzeichnet, daß im Falle der Verwendung eines npn-Transistors als Leistungslement (L) die Versorgungsklemme an das erste Versorgungspotential (U1) gelegt ist, während die zu den Emittern der npn-Transistoren (L, T1, T2, T3) über je einen Vorwiderstand (R1, R2, R6, R7) führende Klemme durch die Ausgangsklemme (A) gegeben ist.

4.) Anordnung nach Anspruch 2, dadurch gekennzeichnet, daß das Leistungselement durch einen npn-Transistor ($L^+$) gegeben und die Versorgungsklemme an das Bezugspotential und außerdem über je einen Vorwiderstand ($R1^+$, $R2^+$, $R6^+$, $R7^+$) an die Emitter der beteiligten Transistoren ($L^+$, $T1^+$, $T2^+$, $T3^+$) gelegt ist.

5.) Anordnung nach einem der Ansprüche 2 bis 4, dadurch gekennzeichnet, daß der Leistungstransistor (L, $L^+$) und der Sondentransistor (T2, $T2^+$) eine gemeinsame Basiszone und eine gemeinsame Kollektorzone haben. (Fig. 3).

6.) Anordnung nach anspruch 3 und 4, <u>dadurch gekennzeichnet</u>, daß in einer Gegentakt-Leistungsstufe zwei Leistungstransistoren (L, L$^+$) vom npn-Typ vorgesehen und mit je einem Schutztransistor (T1, T1$^+$), je einem Darlingtontransistor (T3, T4;T3$^+$, T4$^+$) je einem Sondentransistor (T2, T2$^+$) und je einem Spannungsteiler zusammengeschaltet sind, und daß hierbei der stromführende Ausgang des einen Leistungstransistors an die das erste Versorgungspotential (U1) führende Versorgungsklemme und der stromführende Ausgang des zweiten Leistungstransistors (L$^+$) an die Ausgangsklemme gelegt ist.

1/2

FIG 1

FIG 3

2/2

FIG 2

Europäisches
Patentamt

**EUROPÄISCHER RECHERCHENBERICHT**

0068203
Nummer der Anmeldung

EP 82 10 5041

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| Y | DE-A-2 239 415 (SIEMENS) <br> * Insgesamt * <br><br> --- | 1 | H 03 F 1/52 <br> H 02 H 7/20 |
| Y | US-A-4 021 701 (DAVIES) <br> * Spalte 2, Zeile 58 - Spalte 3, Zeile 22; Spalte 4, Zeile 66 - Spalte 8, Zeile 13; Abbildungen 1-3 * <br><br> --- | 1,3-6 | |
| Y | DE-A-1 809 570 (SONY) <br> * Seite 5, Zeile 21 - Seite 12, Zeile 5; Abbildungen 2-13 * <br><br> --- | 1,2,6 | |
| A | FR-A-2 231 140 (RCA) <br> * Seite 1, Zeile 33 - Seite 5, Zeile 23; Abbildungen 1,2 * & DE - A - 2 424 759 <br><br> --- | 1,3,5 | |
| A | GB-A-2 030 808 (HITACHI) <br><br> ----- | 1,6 | RECHERCHIERTE SACHGEBIETE (Int. Cl. 3) <br><br> H 03 F 1/00 <br> H 02 H 7/00 |

Der vorliegende Recherchenbericht wurde für alle Patentansprüche erstellt.

| Recherchenort | Abschlußdatum der Recherche | Prüfer |
|---|---|---|
| DEN HAAG | 04-10-1982 | RUGGIU M.L.J.J. |